# NEW EUROPEAN PATENT SPECIFICATION

(11) **EP 2 596 064 B2**
(45) Date of publication and mention of the opposition decision: **28.06.2017**
(45) Mention of the grant of the patent: 12.02.2014
(21) Application number: 12709106.4
(22) Date of filing: 16.03.2012
(51) Int. Cl.: C08L 69/00, H05K 1/03, H05K 3/10, C08K 3/22, C08K 9/02, C08L 55/02, H05K 3/18

(54) **PROCESS FOR PRODUCING A CIRCUIT CARRIER**
VERFAHREN ZUR HERSTELLUNG EINES SCHALTUNGSTRÄGERS
PROCÉDÉ DE FABRICATION D'UN SUPPORT DE CIRCUIT

(30) Priority: 18.03.2011 EP 11158893
(43) Date of publication of application: 29.05.2013
(73) Proprietor: Mitsubishi Chemical Europe GmbH, 40549 Düsseldorf (DE)
(72) Inventor: SCHRAUWEN, Bernardus Antonius Gerardus, NL-5595 CL Leende (NL)
(74) Representative: Renkema, Jaap
(86) International application number: PCT/EP2012/054667
(87) International publication number: WO 2012/126831

(56) References cited:
- EP-A1- 2 233 519
- WO-A1-2012/056416
- WO-A2-2009/024496
- DE-A1-102004 045 305
- US-A- 5 599 592
- US-A1- 2004 013 969
- US-A1- 2004 241 422
- US-A1- 2007 032 569
- US-A1- 2009 292 048
- US-B2- 6 693 657
- HÜSKE M ET AL: "Laser supported activation and additive metallization of thermoplastics for 3D-MIDS", PROCEEDINGS OF THE 3RD LANE 2001, AUGUST 28-31, ERLANGEN, GERMANY, 28 March 2001 (2001-03-28), pages 1-12, XP002242586,
- S. ROSENBERGER, M. HOPFNER: "Kunststoffe und Pigmentierungen für das Beschriften und Schweissen mit Laser", WOLF-TECHNOLOGIESEMINAR 28.09.2005, 28 September 2005 (2005-09-28), pages 1-53, XP002638509, Retrieved from the Internet: URL:http://www.wolf-produktionssysteme.de/ veroeffentlichungen/technologieseminar05/v ortrag2.pdf [retrieved on 2011-05-24]
- Safety Data Sheet Merck-Iriotec 8825
- Wikipedia Antimony trioxide
- Römpp online Georg Thieme Verlag KG "Gemische"
- Wikipedia "List of laser types"

## Description

The present invention relates to a process for producing a circuit carrier by a laser direct structuring process. In particular, the present invention relates to a process for producing a circuit carrier, comprising providing a moulded part containing a thermoplastic composition comprising a thermoplastic resin and a laser direct structuring additive and irradiating areas of said part on which conductive tracks are to be formed with laser radiation, and subsequently metalizing the irradiated areas. The invention also relates to a circuit carrier obtainable thereby.

Polymer compositions comprising a polymer and a laser direct structuring (LDS) additive are for example described in US-B2-7060421 and WO-A-2009024496. Such polymer compositions can advantageously be used in an LDS process for producing a nonconductive part on which conductive tracks are to be formed by irradiating areas of said part with laser radiation to activate the plastic surface at locations where the conductive path is to be situated and subsequently metalizing the irradiated areas to accumulate metal on these areas. WO-A-2009024496 describes aromatic polycarbonate compositions containing a metal compound capable of being activated by electromagnetic radiation and thereby forming elemental metal nuclei and 2.5-50 wt% of a rubber like polymer, the latter being added to reduce degradation of the polycarbonate due to the presence of such metal compound in aromatic polycarbonate compositions. However, the presence of rubber-like polymer in substantial amount is disadvantageous in some applications, in particular high temperature applications, such as parts that require soldering. As an alternative, rubber like polymers may be used in small amounts, typically in a range of 0-2.4 wt% combined with a sulphonate salt. Such composition are described in a copending application PCT/EP2010/070227.

It is a disadvantage of the polymer compositions comprising the previously mentioned laser direct structuring (LDS) additive that up until now only compositions with limited colours such as black or grey were known to be feasible.

In some electronic field of applications, for example in the field of mobile phones which is a very large market, there exists a need for aforementioned polymer compositions in different colours, in particular light colours such as white.

The object of the present invention is to provide an LDS process using a thermoplastic composition comprising a laser direct structuring additive, which thermoplastic composition has colours, in particular light colours such as white. Furthermore the composition should be suitable for making a circuit carrier via for example an electroless copper plating process. The composition should also have sufficient mechanical properties.

This object is achieved by a process for producing a circuit carrier, comprising providing a moulded part containing a thermoplastic composition comprising:
a) a thermoplastic resin and
b) a laser direct structuring additive in an amount of at least 1 wt% with respect to the weight of the total composition, the laser direct structuring additive comprising antimony-doped tin oxide and having a CIELab colour value L* of at least 45 and irradiating areas of said part on which conductive tracks are to be formed with laser radiation, and subsequently metalizing the irradiated areas, wherein the laser radiation is infrared light.

As used herein, the L* value of a colour is a measure for the lightness of a colour according to the Commission Internationale de l'Eclairage L*a*b* colour space (CIE 1976: hereinafter "CIELab"). The L*a*b* colourimetric system was standardized in 1976 by Commission Internationale de l'Eclairage (CIE). The CIELab L* value, utilized herein to define the darkness/lightness of the polymer composition according to the present invention, is a unit of colour measurement in the afore-mentioned CIELab system. A colour may be matched according to CIELab. In the L*a*b* colourimetric system, L* refers to lightness expressed by a numerical value of from 0 to 100, in which L*=0 means that the colour is complete black, and L*=100 means that the colour is complete white.

Surprisingly, the inventors have found that the specific laser direct structuring additive used according to the present invention allows the thermoplastic composition to have a light colour while giving a high plating performance. The possibility to obtain a thermoplastic composition having a light colour allows tuning of the colour of the thermoplastic composition by addition of corresponding colorants. In comparison, the laser direct structuring additives used in known compositions give the thermoplastic composition darker colours which make it difficult to tune colours, especially to provide a white colour.

Preferably, the thermoplastic composition according to the present invention without colorants has a colour value L* of at least 45, more preferably 60, more preferably 75. The higher colour value L* obtainable without colorants allows an easy tuning of the colour of the thermoplastic composition with a smaller amount of colorants. This is advantageous for the mechanical properties of the thermoplastic composition. Preferably, the laser direct structuring additive has a CIELAB colour value L* of at least 50, more preferably at least 60, more preferably at least 75. The higher colour value L* of the laser direct structuring additive was found to result in a higher colour value L* of the thermoplastic composition.

Preferably, the laser direct structuring additive has a CIELAB colour value a* of between - 10 and +10 and value b* of between -10 and +10. More preferably, the laser direct structuring additive has a CIELAB colour value a* of between -6 and +6 and value b* of between -6 and +6. The low absolute values of a* and b* in combination with high L* value allows obtaining a thermoplastic composition of white colour.

The laser direct structuring additive comprises antimony-doped tin oxide. This was found to result in a light colour and a high plating performance, as well as a high mechanical strength. Mica was found to further improve the plating performance in combination with antimony-doped tin oxide. Particularly preferred laser direct structuring additive comprises mica coated with antimony-doped tin oxide.

The concentration of the component b) present in the composition of the present invention is at least 1 wt%, preferably between 2 wt% and 25 wt%, more preferably between 3 and 20 wt%, even more preferably between 4 wt% and 15 wt%, and particularly preferably from 5 wt% up to 10 wt%, with respect to the weight of the total composition.

The concentration of a) thermoplastic resin in the composition of the present invention is preferably between 45 wt% and 99 wt%, more preferably between 70 wt% and 97 wt%, with respect to the weight of the total composition.

The thermoplastic composition according to the present invention may further comprise c) a colorant. The final colour of the thermoplastic composition can thereby be tuned.

Colorants are usually classified into the following three categories: inorganic pigments, organic pigments and dyes (or solvent dyes). The characterizing difference between pigments and dyes is the difference in solubility. Pigments are virtually insoluble in the medium in which they are used, also under processing conditions. They consist of solid crystalline particles that must be dispersed in the polymer in a physical/mechanical way. The colour of a pigment is not only dependent on molecular structure, but also on crystal structure and morphology. The colour of a polymer/pigment composition is therefore dependent on the quality of the dispersion. Dyes on the other hand are compounds that are soluble under the processing conditions and/or conditions of use. They commonly show an intrinsic affinity with a polymer substrate, and can for example adsorb to a substrate from a solution. Dyes can mix with polymers on a molecular scale, and as a result they can give clear and transparent colours, with high colour intensity. In certain cases dyes are therefore preferred to pigments. In other cases pigments are preferred to dyes. When present, the amount of the colorants may be at least 0.1 wt% with respect to the weight of the total composition. Preferably, the amount of the pigments is at most 20 wt%, more preferably at most 10 wt%.

Particularly preferred is a white pigment. A white thermoplastic composition can be thereby obtained. Furthermore, the white pigment increases the L* value of the thermoplastic composition, making it easier to give the thermoplastic composition a desired colour by using pigments of choice in combination with it. Examples of the white pigments include TiO₂, BaSO₄ or ZnO.

Surprisingly, TiO₂ was found not only to increase the colour value L*, but it also resulted in a surprisingly high plating performance. Furthermore, this combination of the laser direct structuring additive and the white pigment surprisingly allows plating even at a low laser energy broadening the laser operation window. Variations in frequency, power, marking speed and/or focal distance do not result in a strong decrease in contrast compared to the optimum contrast obtained using optimum laser settings. Accordingly, a particularly preferred embodiment of the present invention relates to a process wherein the thermoplastic composition comprises: a) a thermoplastic resin, b) a laser direct structuring additive in an amount of at least 1 wt% with respect to the weight of the total composition, the laser direct structuring additive containing antimony-doped tin oxide and having a CIELab colour value L* of at least 45, and c) TiO₂. The amount of TiO₂ is preferably at least 1 wt% , more preferably at least 5 wt%, with respect to the weight of the total composition. Preferably, the amount of the pigments is at most 20 wt%, more preferably at most 10 wt%.with respect to the weight of the total composition.

Accordingly, the present invention relates to use of TiO₂ for improving plating performance in a laser direct structuring process for producing a circuit carrier from a thermoplastic composition comprising: a) a thermoplastic resin and b) a laser direct structuring additive in an amount of at least 1 wt% with respect to the weight of the total composition, the laser direct structuring additive containing antimony-doped tin oxide and having a CIELab colour value L* of at least 45.

Other pigments for giving the thermoplastic composition desired colours are known to the skilled person and are commercially available. Known pigments include metal oxides available from companies such as Ferro, The Shepherd Color Company, Heubach, Rockwood Pigments, Tomatec and Broll-Buntpigmente.

Dyes for giving the thermoplastic composition desired colours are known and are commercially available to the skilled person. Known suitable dyes include Macrolex series from Lanxess such as Macrolex Red 5B and Sicotan series from BASF such as Sicotan Yellow K1010.

The thermoplastic composition according to the present invention may further comprise d) a mineral filler selected from the group consisting of mica, talk and wollastonite, preferably in an amount of at least 1 wt% with respect to the weight of the total composition. The mineral filler was found to improve the plating performance. Preferably, the amount of the mineral filler is at most 10 wt%.

Examples of thermoplastic resins that may be present in the composition according to the invention include, but are not limited to polycarbonate, in particular aromatic polycarbonate, polyamide, polyester, polyesteramide, polystyrene, polymethyl methacrylate or a combination of such resins. The resins may be homopolymers, copolymers or mixtures thereof, and may be branched or non-branched.

Examples of suitable polyamides (PA) are aliphatic polyamides, that may eventually be branched polyamides, such as PA6, PA46, PA66, PA6/66, PA 11, PA12, semi aromatic polyamides as MXD6, PA6I/6T, PA66/6T, PA4T fully aromatic polyamides and copolymers and blends of the listed polyamides. Examples of suitable polyesters are polyethylene terephtalate (PET), polybutylene terephtalate (PBT), polypropylene terephtalate (PPT), polyethylene naphtanoate (PEN), polybutylene naphtanoate (PBN). Preferred polyesters are polyethylene terephtalate and polybutylene terephtalate.

In preferred embodiments, the thermoplastic resin comprises a polycarbonate-based resin. The polycarbonate-based resin may be selected from a polycarbonate or a resin blend that includes a polycarbonate. The polycarbonates may be homopolymers, copolymers and mixtures thereof, and may be branched or non-branched. Suitable polycarbonate-based resins are described e.g. in US2009/0292048, which is incorporated herein by reference.

Polycarbonates including aromatic carbonate chain units include compositions having structural units of the formula (I):

-R¹-O-CO-O- (I)

in which the R¹ groups are aromatic, aliphatic or alicyclic radicals. Beneficially, R¹ is an aromatic organic radical and, in an alternative embodiment, a radical of the formula (II):

-A¹-Y¹-A²- (II)

wherein each of A¹ and A² is a monocyclic divalent aryl radical and Y¹ is a bridging radical having zero, one, or two atoms which separate A¹ from A². In an exemplary embodiment, one atom separates A¹ from A². Illustrative examples of radicals of this type are -O-, -S-, - S(O)-, -S(O2)-, -C(O)-, methylene, cyclohexyl-methylene, 2-[2,2,1]-bicycloheptylidene, ethylidene, isopropylidene, neopentylidene, cyclohexylidene, cyclopentadecylidene, cyclododecylidene, adamantylidene, or the like. In another embodiment, zero atoms separate A¹ from A², with an illustrative example being bisphenol. The bridging radical Y¹ can be a hydrocarbon group or a saturated hydrocarbon group such as methylene, cyclohexylidene or isopropylidene.

Suitable aromatic polycarbonates include polycarbonates made from at least a divalent phenol and a carbonate precursor, for example by means of the commonly known interfacial polymerization process or the melt polymersiation method. Suitable divalent phenols that may be applied are compounds having one or more aromatic rings that contain two hydroxy groups, each of which is directly linked to a carbon atom forming part of an aromatic ring. Examples of such compounds are:
4,4'-dihydroxybiphenyl, 2,2-bis(4-hydroxyphenyl)propane (bisphenol A),
2,2-bis(4-hydroxy-3-methylphenyl)propane, 2,2-bis-(3-chloro-4-hydroxyphenyl)-propane,
2,2-bis-(3,5-dimethy4-4-hydroxyphenyl)-propane,
2,4-bis-(4-hydroxyphenyl)-2-methylbutane,
2,4-bis-(3,5-dimethyl-4-hydroxyphenyl)-2-methylbutane, 4,4-bis(4-hydroxyphenyl)heptane, bis-(3,5-dimethyl-4-hydroxyphenyl)-methane, 1,1-bis-(4-hydroxyphenyl)-cyclohexane,
1,1 -bis-(3,5-dimethyl-4-hydroxyphenyl)-cyclohexane,
2,2-(3,5,3',5'-tetrachloro-4,4'-dihydroxydiphenyl)propane,
2,2-(3,5,3',5'-tetrabromo-4,4'-dihydroxydiphenyl)propane,
(3,3'-dichloro-4,4'-dihydroxyphenyl)methane, bis-(3,5-dimethyl-4-hydroxyphenyl)-sulphon, bis-4-hydroxyphenylsulphon, bis-4-hydroxyphenylsulphide.

The carbonate precursor may be a carbonyl halogenide, a halogen formate or carbonate ester. Examples of carbonyl halogenides are carbonyl chloride and carbonyl bromide. Examples of suitable halogen formates are bis-halogen formates of divalent phenols such as hydroquinone or of glycols such as ethylene glycol. Examples of suitable carbonate esters are diphenyl carbonate, di(chlorophenyl)carbonate, di(bromophenyl)carbonate, di(alkylphenyl)carbonate, phenyltolylcarbonate and the like and mixtures thereof. Although other carbonate precursors may also be used, it is preferred to use the carbonyl halogenides and in particular carbonylchloride, also known as phosgene.

The aromatic polycarbonates in the composition according to the invention may be prepared using a catalyst, an acid acceptor and a compound for controlling the molecular mass.

Examples of catalysts are tertiary amines such as triethylamine, tripropylamine and N,N-dimethylaniline, quaternary ammonium compounds such as tetraethylammoniumbromide and quaternary phosphonium compounds such as methyltriphenylfosfoniumbromide.

Examples of organic acid acceptors are pyridine, triethylamine, dimethylaniline and so forth. Examples of inorganic acid acceptors are hydroxides, carbonates, bicarbonates and phosphates of an alkali metal or earth alkali metal.

Examples of compounds for controlling the molecular mass are monovalent phenols such as phenol, p-alkylphenols and para-bromophenol and secondary amines.

The thermoplastic resin may be a blend of, on one hand, resins such as polycarbonate, polyamide, polyester, polyesteramide, polystyrene, polymethyl methacrylate, and on the other hand, at least one rubber like polymer. Examples of rubber-like polymer are described in WO-A-2009024496, which is incorporated herein by reference. Particularly preferred is a blend of polycarbonate and the rubber-like polymer. The rubber- like polymer is or contains an elastomeric (i.e. rubbery) polymer having preferably a Tg less than about 10 °C, more specifically less than about -10 °C, or more specifically about -20 °C to -80 °C.

Examples of elastomeric polymers include polyisoprene; butadiene based rubbers like polybutadiene, styrene-butadiene random copolymer and block copolymer, hydrogenates of said block copolymers, acrylonitrile-butadiene copolymer and butadiene-isoprene copolymer; acrylate based rubbers like ethylene- methacrylate and ethylene-butylacrylate, acrylate ester-butadiene copolymers, for example acrylic elastomeric polymers such as butylacrylate-butadiene copolymer; siloxane based rubbers like polyorganosiloxanes such as for example polydimethylsiloxane, polymethylphenylsiloxane and dimethyldiphenylsiloxane copolymer; and other elastomeric polymers like ethylene-propylene random copolymer and block copolymer, copolymers of ethylene and [alpha]-olefins, copolymers of ethylene and aliphatic vinyl such as ethylene-vinyl acetate, and ethylene-propylene non- conjugated diene terpolymers such as ethylene-propylene-hexadiene copolymer, butylene-isoprene copolymer, and chlorinated polyethylene, and these substances may be used individually or in combinations of two or more.

Particularly preferred elastomeric polymers include ABS resin (acrylonitrile- butadienestyrene copolymer), AES resin (acrylonitrile-ethylene-propylene-styrene copolymer), AAS resin (acrylonitrile-acrylic elastomer-styrene copolymer), and MBS (methyl methacrylate butadiene styrene copolymer). Particularly preferred graft copolymers are acrylonitrile butadiene styrene rubber (ABS), methylmethacrylate butadiene styrene rubber (MBS) or a mixture of these copolymers, because of the high compatibility between the polycarbonate matrix and such copolymers, thereby enabling that these copolymers can be uniformly dispersed into the polycarbonate matrix. This decreases any degradation of the thermoplastic resin that may be caused by certain types of component b). From an economic point of view acrylonitrile butadiene styrene (ABS) is even more preferred. Any commercially available ABS may be applied. Particularly preferred acrylonitrile butadiene styrene (ABS) is acrylonitrile butadiene styrene a rubber content of 10 to 50 parts by weight, preferably 10 to 40 parts by weight and even more preferably 10 to 30 parts by weight.

Preferably, the concentration of the rubber-like polymer in the thermoplastic resin a) is 0-60 wt% of the amount of the thermoplastic resin a).

The thermoplastic composition contains a laser direct structuring additive (component b)) that enables the composition to be used in a laser direct structuring (LDS) process. In an LDS process, a laser beam exposes the LDS additive to place it near or at the surface of the thermoplastic composition and to release metal particles from the LDS additive. As such, the LDS additive is selected such that, upon exposure to a laser beam, a conductive path can be formed by selective metallization in a standard electroless plating process, such as a copper plating process, on the areas exposed and no metallization occurs on the areas that are not exposed.

Without wanting to be bound by any theory, it is believed that the laser direct structuring additive (component (b)) may be capable of being activated by laser radiation and thereby form elemental metal particles. It is believed that these metal particles act as nuclei for copper deposition in a standard electroless copper plating process and form the basis for the formation of Cu circuits on the polycarbonate. It is also possible that the radiation is not directly absorbed by the laser direct structuring additive, but is absorbed by other substances which then transfer the absorbed energy to the laser direct structuring additive and thus bring about the liberation of elemental metal.

Component b) according to the present invention not only enables the composition to be used in a laser direct structuring (LDS) process, but also provides light colour to the thermoplastic composition.

The laser radiation infrared light (wavelength from 800 to 25 000 nm). The laser radiation is infrared light radiation, more preferably with a wavelength of 1064 nm.

The thermoplastic composition according to the invention may further comprise from 0 up to 25 wt% of one or more other additives, relative to the total weight of the composition. These include the customary additives such as stabilizers against thermal or thermooxidative degradation, stabilizers against hydrolytic degradation, stabilizers against degradation from light, in particular UV light, and/or photo-oxidative degradation, anti-drip agents such as for example PTFE, processing aids such as release agents and lubricants, colourants such as pigments and dyes. Suitable examples of such additives and their customary amounts are stated in the aforementioned Kunststoff Handbuch, 3/1.

Preferably, the thermoplastic composition according to the present invention comprises a) 45-99 wt% of the thermoplastic resin, b) 1-25 wt% of the laser direct structuring additive, c) 0-20 wt% of the colorant and d) 0-10 wt% of the mineral filler. The thermoplastic composition according to the present invention may further comprise 0-25 wt%, preferably 0.5-5 wt%, of the other additives. Thus, total amounts of the components a), b), c) and d) is 75-100 wt%, preferably 95-99.5 wt%, with respect to the total weight of the composition. Preferably, the concentration of the rubber-like polymer in the thermoplastic resin is 0-50 wt% of the amount of the thermoplastic resin a).

In preferred embodiments, the thermoplastic composition according to the present invention comprises a) 70-97 wt% of the thermoplastic resin, b) 1-10 wt% of the laser direct structuring additive, c) 1-10 wt% of the colorant and d) 1-10 wt% of the mineral filler.

In addition to the components described above, reinforcing agents such as glass fibres can be added to the thermoplastic composition according to the present invention. It is to be understood that the reinforcing agents such as glass fibres are not included in the weight of the total composition of the thermoplastic composition according to the present invention for the calculation of the concentration of each of the components. The weight ratio of the reinforcing agents such as glass fibres to the thermoplastic composition according to the present invention may be at most e.g. 1:1 or 1:2, and at least e.g. 1:20 or 1:10. Accordingly, the present invention provides a composition comprising the thermoplastic composition according to the present invention and reinforcing agents such as glass fibres.

The components b) and optionally c), d) and other additives as described above may be introduced into the thermoplastic resin a) by means of suitable mixing devices such as single-screw or twin-screw extruders, preferably a twin-screw extruder is used. Preferably, thermoplastic resin pellets are introduced into the extruder together with at least components b) and extruded, then quenched in a water bath and then pelletized. The invention therefore further relates to a process for producing a thermoplastic composition according to the present invention by melt mixing components a), b), and other (particulate) additives and reinforcing agents.

The invention further relates to moulded parts that contains the thermoplastic composition according to the present invention. The invention relates in particular to a moulded part produced by injection moulding of the composition according to the invention. The invention further also relates to an article, in particular a circuit carrier, that contains a moulded part produced from the composition according to the invention. In one embodiment, such a circuit carrier is used for producing an antenna.

The invention further relates to a process for producing such a circuit carrier which process comprises the steps of providing a moulded part that contains the thermoplastic composition according to the present invention, irradiating areas of said part on which conductive tracks are to be formed with laser radiation, and subsequently metallizing the irradiated areas. In a preferred embodiment, the laser irradiation is used to simultaneously release metal nuclei and effect ablation of the part while forming an adhesion-promoting surface. This provides a simple means to achieve excellent adhesive strength of the deposited metallic conductor tracks. The wavelength of the laser is advantageously 1064 nm or of even 10600 nm. The deposition of further metal onto the metal nuclei generated by laser radiation preferably takes place via plating processes. Said metallization is preferably performed by immersing the moulded part in at least one electroless plating bath to form electrically conductive pathways on the irradiated areas of the moulded part. Non-limiting examples of electroless plating processes are a copper plating process, gold plating process, nickel plating process, silver plating, zinc plating and tin plating.

The invention will now be elucidated with reference to the following examples and comparative experiments.

### EXAMPLES

The compositions of Comparative Experiments CEx 1-6 and of the Examples Ex 1 to Ex 7 were prepared from the components as given in Table 1. Additionally, additives for processing and stabilization were added similar to the additives used in the Comparative Examples based on the LDS additive 1 (CEx 1 & CEx 3), depending on the base resins used (PC-ABS or PC). These additives include Mold Release Agent (Loxiol P861/3.5, supplied by Cognis), Heat Stabilizer (Irgafos 168, supplied by BASF), Antioxidant (Irganox 1076, supplied by BASF), Potassium Perfluoro Butane Sulfonate (RM65, supplied by Miteni) and Mono Zinc Phosphate (Z 21-82, supplied by Budenheim).

All sample compositions were prepared according the amounts as given in Table 3 to 6. All amounts are in weight percentage. In each of the experiments, samples were extruded on a co-rotating twin screw extruder at a temperature of 280°. The extrudate was granulated and the collected granulate was dried for 4 hours at a temperature of 100°C and subsequently injection moulded into plaques of 70*50*2mm and ASTM-sized Izod bars (64*12.7*3.2 mm) using a melt temperature of approximately 260°C-270°C.

The lightness L* value of the colour of the thermoplastic composition was measured as follows: A granule sample of the polymer composition is injection moulded to obtain plaques having a thickness of 2 mm. These plaques are measured using a Minolta 3700d as spectrophotometer with diffuse/8° geometry. A CIE Standard illuminant D65 is used as light source and 10° is used as standard Observer. Colour space is CIE Lab 76. Instrument settings are specular included, reflectance measuring on a measuring area of 380-720 nm. Average value of 3 measurements is used as the colour value. The L* value in the CIELab model represent the luminance of the colour.

The lightness L* value of the colour of the LDS additives were measured as a powder, instead of moulding them into plaques. The measuring conditions were the same as the measuring conditions of the thermoplastic composition.

Izod Notched impact strength was measured according to ISO180/4A at a temperature of 23°C and -20°C.

Plating performance was judged after laser activation of the injection molded plaques using different laser power and frequency and a subsequent plating procedure in an electroless McDermid M-Copper 85 plating bath. Plating performance was judged according to the thickness of the copper layer that was built up in approximately 30 to 60 minutes, depending on the deposition speed. The copper thickness was measured using an X-ray fluorescence measurement technique. Since the deposition speed of the copper build up is highly dependent on the condition of the plating bath, a reference material was included that is known to give a stable copper build up performance. The plating performance of the tested material is given by the so called Plating Index, which is the ratio of the copper thickness of the tested material to the copper thickness that is build up on the reference material. For the reference material Pocan DP 7102 is used and the plating time was set to build a copper thickness of approximately 3.5 to 5.5 µm on this reference material.

### Examples 1-2 and Comparative Experiments 1-2

Table 3 shows the compositions and results of Comparative Example (CEx) 1 and 2 and Examples (Ex) 1 and 2.

CEx 1, 2 and Ex 1, 2 show that mica coated with antimony-doped tin oxide (LDS additive 2) can be used as laser direct structuring additive instead of CuCr₂O₄ (LDS additive 1) for the polycarbonate composition including PC and ABS and MBS. The composition can be laser structured and plating occurs to a satisfactory level.

The colour value L* of the thermoplastic composition is much higher when the LDS additive 2 is used instead of LDS additive 1. Use of LDS additive 1 alone results in a very low colour value (CEx 1). Even when a large amount of white pigment is used in combination with LDS additive 1 (CEx 2), the colour value is lower than when the LDS additive 2 is used with a small amount of white pigment (Ex1, 2). Further, the addition of the white pigment to LDS additive 1 did not influence the plating performance (CEx 1, CEx 2).

From Ex 1 and 2, it can be seen that the increase in the amount of the LDS additive 2 improves the plating performance especially at a lower plating power.

### Examples 3-4 and Comparative Experiment 3

Table 4 shows the compositions and results of Comparative Example (CEx) 3 and Examples (Ex) 3 and 4.

CEx 3 and Ex 3, 4 show that mica coated with antimony-doped tin oxide (LDS additive 2) can be used as laser direct structuring additive instead of CuCr₂O₄ for the polycarbonate composition including PC without ABS or MBS. The composition can be laser structured and plating occurs to a satisfactory level.

Comparison of Ex 3, 4 shows that the addition of the white pigment to LDS additive 2 greatly improves the plating performance especially at a lower plating power.

Ex 3 shows that LDS additive 1 gives a high colour value L* even without the use of white pigment.

Izod notched impact is improved by the use of ABS/MBS in combination with PC.

### Examples 5-7 and Comparative Experiment 1, 2 and 4

Table 5 shows the compositions and results of Comparative Example (CEx) 1, 2 and 4 and Examples (Ex) 5 to 7.

CEx 1, 2 and Ex 5 to 7 show that mica coated with antimony-doped tin oxide (LDS additive 2) can be used as laser direct structuring additive instead of CuCr₂O₄ (LDS additive 1) for the polycarbonate composition including PC and ABS and MBS. The composition can be laser structured and plating occurs to a satisfactory level.

The addition of the white pigment greatly improves the plating performance especially at a lower plating power.

The colour value L* is much higher when the LDS additive 2 is used instead of LDS additive 1.

CEx 4 shows that the colour value L* is very high but no plating occurs when no LDS additive is added. Mica and the white pigment do not work as an LDS additive by themselves.

Izod notched impact is at a reasonable level for all samples.

### Comparative Experiment 5-6

Table 6 shows the compositions and results of Comparative Example (CEx) 5-6.

CEx 5 shows that laser marking additive containing bismuth, but not containing tin, does not work as an LDS additive.

CEx 6 shows that the colour value L* is very high but no plating occurs when no LDS additive is added. This shows that an IR absorption is not enough for plating to occur.

**Table 1**

| **Material** | **Type** | **Supplier** |
|---|---|---|
| Polycarbonate (PC) | LVN (ISO 1628/4) = 47.5 - 52.5 ml/g | MEP |
| ABS | Santac ST-55 | Mitsui Germany |
| MBS | Kane Ace M511 | Kaneka |
| LDS Additive 1 | Black 1G (CuCr₂O₄) | Shepherd Color Company |
| LDS Additive 2 | Lazerflair 825 (Mica coated with antimony-doped tin oxide) | Merck KGaA |
| Laser Marking Additive | 42-920A (Bi₂O₃ + Nd₂O₃) | Tomatec |
| Laser IR Absorber | Lumogen IR 1050 | BASF |
| White Pigment | Kronos 2233 (TiO2) | Kronos |

**Table 2**

| **Material** | **LDS additive 1** | **LDS Additive 2** |
|---|---|---|
| Properties - Colour | | |
| Colour value - L* | 39.1 | 85.4 |
| Colour value - a* | -0.1 | -2.0 |
| Colour value - b* | 1.8 | 1.7 |

**Table 3**

| **Sample** | | **CEx 1** | **CEx 2** | **Ex 1** | **Ex 2** |
|---|---|---|---|---|---|
| Components | Units | | | | |
| PC | % | 56 | 49 | 60 | 58 |
| ABS | % | 30 | 30 | 30 | 30 |
| MBS | % | 5 | 5 | 5 | 5 |
| LDS Additive 1 | % | 8 | 5 | | |
| LDS Additive 2 | % | | | 3 | 5 |
| White Pigment | % | | 10 | 1 | 1 |
| Other Additives | % | 1 | 1 | 1 | 1 |
| Total | % | 100 | 100 | 100 | 100 |
| | | | | | |

| Properties - Mechanical | | | | | |
|---|---|---|---|---|---|
| Izod Notched Impact @ 23°C | kJ/m² | 73 | 83 | 57 | 51 |
| Izod Notched Impact @ -20°C | kJ/m² | 53 | 60 | 41 | 34 |

| Properties - Color | | | | | |
|---|---|---|---|---|---|
| Color value - L* | - | 30 | 55 | 77 | 74 |
| Color value - a* | - | 0.1 | -1.9 | -2.2 | -2.6 |
| Color value - b* | - | -1.9 | -7 | 2 | 1.3 |

| Properties - Plating | | | | | |
|---|---|---|---|---|---|
| Plating Index @ 5W-60kHz | - | 0.74 | 0.74 | | |
| Plating Index @ 7W-60kHz | - | 0.75 | 0.69 | | |
| Plating Index @ 9W-60kHz | - | | | 0.33 | 0.56 |
| Plating Index @ 11W-80kHz | - | | | 0.48 | 0.56 |
| Plating Index @ 13W-80kHz | - | | | 0.42 | 0.55 |
| Plating Index @ 13W-100KHz | - | | | 0.48 | 0.52 |
| Plating Index @ 15W-100kHz | - | | | 0.48 | 0.5 |

**Table 4**

| **Sample** | | **CEx 3** | **Ex 3** | **Ex 4** |
|---|---|---|---|---|
| Components | Units | | | |
| PC | % | 91.1 | 96.1 | 93.1 |
| LDS Additive 1 | % | 8 | | |
| LDS Additive 2 | % | | 3 | 5 |
| White Pigment | % | | | 1 |
| Other Additives | % | 0.9 | 0.9 | 0.9 |
| Total | % | 100 | 100 | 100 |

| Properties - Color | | | | |
|---|---|---|---|---|
| Color value - L* | - | 29 | 63 | 75 |
| Color value - a* | - | 0.2 | -4.1 | -2.8 |
| Color value - b* | - | -1.3 | -1.9 | 1.3 |

| Properties - Plating | | | | |
|---|---|---|---|---|
| Plating Index @ 5W-60kHz | - | 0.62 | | |
| Plating Index @ 7W-60kHz | - | 0.64 | | |
| Plating Index @ 9W-60kHz | - | | 0.11 | 0.49 |
| Plating Index @ 11W-80kHz | - | | 0.14 | 0.59 |
| Plating Index @ 13W-80kHz | - | | 0.39 | 0.65 |
| Plating Index @ 13W-100kHz | - | | 0.27 | 0.65 |
| Plating Index @ 15W-100kHz | - | | 0.52 | 0.61 |

**Table 5**

| **Sample** | | **CEx 1** | **CEx 2** | **CEx 4** | **Ex 5** | **Ex 6** | **Ex 7** |
|---|---|---|---|---|---|---|---|
| Components | Units | | | | | | |
| PC | % | 56 | 49 | 54 | 59 | 54 | 49 |
| ABS | % | 30 | 30 | 30 | 30 | 30 | 30 |
| MBS | % | 5 | 5 | 5 | 5 | 5 | 5 |
| LDS Additive 1 | % | 8 | 5 | | | | |
| LDS Additive 2 | % | | | | 5 | 5 | 5 |
| Mica | % | | | 5 | | | |
| White Pigment | % | | 10 | 5 | | 5 | 10 |
| Other Additives | % | 1 | 1 | 1 | 1 | 1 | 1 |
| Total | % | 100 | 100 | 100 | 100 | 100 | 100 |
| | | | | | | | |

| Properties - Mechanical | | | | | | | |
|---|---|---|---|---|---|---|---|
| Izod Notched Impact @ 23°C | kJ/m² | 73 | 83 | 48 | 56 | 49 | 41 |
| Izod Notched Impact @ -20°C | kJ/m² | 53 | 60 | 22 | 35 | 33 | 22 |

| Properties - Color | | | | | | | |
|---|---|---|---|---|---|---|---|
| Color value - L* | - | 30 | 55 | 95 | 64 | 87 | 90 |
| Color value - a* | - | 0.1 | -1.9 | -0.5 | -3.9 | -2.3 | -1.9 |
| Color value - b* | - | -1.9 | -7 | 2.7 | 0.2 | 1.5 | 1.2 |

| Properties - Plating | | | | | | | |
|---|---|---|---|---|---|---|---|
| Plating Index @ 5W-60kHz | - | 0.74 | 0.74 | 0.0 | 0.0 | 0.05 | 0.27 |
| Plating Index @ 7W-60kHz | - | 0.75 | 0.69 | 0.0 | 0.0 | 0.61 | 0.81 |
| Plating Index @ 9W-60kHz | - | | | 0.0 | 0.09 | 0.72 | 0.81 |
| Plating Index @ 9W-80kHz | - | | | 0.0 | 0.0 | 0.79 | 0.83 |
| Plating Index @ 11W-80kHz | - | | | 0.0 | 0.15 | 0.77 | 0.59 |
| Plating Index @ 13W-80kHz | - | | | 0.0 | 0.48 | 0.69 | 0.54 |
| Plating Index @ 13W-100kHz | - | | | 0.0 | 0.3 | 0.78 | 0.58 |
| Plating Index @ 15W-100kHz | - | | | 0.0 | 0.57 | 0.63 | 0.46 |
| Plating Index @ 17W-100kHz | - | | | 0.0 | 0.82 | 0.43 | 0.43 |

**Table 6**

| **Sample** | | **CEx 5** | **CEx 6** |
|---|---|---|---|
| Components | Units | | |
| PC | % | 54 | 52 |
| ABS | % | 30 | 30 |
| MBS | % | 5 | 5 |
| LDS Additive 1 | % | | |
| LDS Additive 3 | % | | |
| Laser Marking Additive | % | 5 | |
| Laser IR absorber | % | | 2 |
| White Pigment | % | 5 | 10 |
| Mica | % | | |
| Other Additives | % | 1 | 1 |
| Total | % | 100 | 100 |
| | | | |

| Properties - Color | | | |
|---|---|---|---|
| Color value - L* | - | 68 | 90 |
| Color value - a* | - | -0.6 | -3.1 |
| Color value - b* | - | 1.5 | 0.9 |

| Properties - Plating | | | |
|---|---|---|---|
| Plating Index @ 5W-60kHz | - | 0.0 | 0.0 |
| Plating Index @ 7W-60kHz | - | 0.0 | 0.0 |
| Plating Index @ 9W-60kHz | - | 0.0 | 0.0 |
| Plating Index @ 9W-80kHz | - | 0.0 | 0.0 |
| Plating Index @ 11W-80kHz | | 0.0 | 0.0 |
| Plating Index @ 13W-80kHz | - | 0.0 | 0.0 |
| Plating Index @ 13W-100kHz | - | 0.0 | 0.0 |
| Plating Index @ 15W-100kHz | - | 0.0 | 0.0 |
| Plating Index @ 17W-100kHz | - | 0.0 | 0.0 |

## Claims

1. Process for producing a circuit carrier, comprising providing a moulded part containing a thermoplastic composition comprising:
a) a thermoplastic resin and
b) a laser direct structuring additive in an amount of at least 1 wt% with respect to the weight of the total composition, the laser direct structuring additive comprising antimony-doped tin oxide and having a CIELab colour value L* of at least 45 and
irradiating areas of said part on which conductive tracks are to be formed with laser radiation, and subsequently metalizing the irradiated areas, wherein the laser radiation is infrared light.

2. Process according to claim 1, wherein the thermoplastic resin is a polycarbonate-based resin.

3. Process according to any one of the previous claims, wherein the thermoplastic composition comprises the thermoplastic resin in an amount of between 45 wt% and 99 wt%, preferably between 70 wt% and 97 wt%, with respect to the weight of the total composition.

4. Process according to any one of the previous claims, wherein the laser direct structuring additive has a CIELab colour value L* of at least 50, more preferably at least 60, more preferably at least 75.

5. Process according to any one of the previous claims, wherein the laser direct structuring additive has a CIELAB colour value a* of between -10 and +10 and value b* of between -10 and +10.

6. Process according to any one of the previous claims, wherein the laser direct structuring additive comprises mica on which the antimony-doped tin oxide is coated.

7. Process according to any one of the previous claims, wherein the thermoplastic composition comprises the laser direct structuring additive in an amount of between 2 wt% and 25 wt%, more preferably between 3 and 20 wt%, even more preferably between 4 wt% and 15 wt%, and particularly preferably from 5 wt% up to 10 wt%, with respect to the weight of the total composition.

8. Process according to any one of the previous claims, further comprising c) a pigment preferably in an amount of at least 1 wt% with respect to the weight of the total composition.

9. Process according to claim 8. wherein the pigment comprises a white pigment selected from the group consisting of TiO₂, BaSO₄ or ZnO.

10. Process according to claim 8 or 9, wherein the thermoplastic composition comprises the pigment comprises in an amount of at least 5 wt% and preferably at most 20 wt%, more preferably at most 10 wt%, with respect to the weight of the total composition.

11. Process according to any one of the previous claims, further comprising d) a mineral filler selected from the group consisting of mica, talk and wollastonite, preferably in an amount of at least 1 wt% and at most 10 wt%.

12. Use of TiO₂ for improving plating performance in a laser direct structuring process for producing a circuit carrier from a thermoplastic composition comprising: a) a thermoplastic resin and b) a laser direct structuring additive in an amount of at least 1 wt% with respect to the weight of the total composition, the laser direct structuring additive containing antimony-doped tin oxide and having a CIELab colour value L* of at least 45, wherein the laser radiation is infrared light.

## Patentansprüche

1. Verfahren zur Herstellung eines Schaltungsträgers, umfassend das Bereitstellen eines geformten Teils, der eine thermoplastische Zusammensetzung enthält, umfassend:
a) ein thermoplastisches Harz und
b) einen Laser-Direktstrukturierungszusatz in einer Menge von mindestens 1 Gew% in Bezug auf das Gewicht der gesamten Zusammensetzung, wobei der Laser-Direktstrukturierungszusatz Antimon-dotiertes Zinnoxid umfasst und einen CIELab Farbwert L* von mindestens 45 aufweist, und
bestrahlen von Flächen des Teils, auf dem leitende Bahnen zu bilden sind, mit Laserstrahlung und anschließend Metallisieren der bestrahlten Flächen, wobei die Laserstrahlung Infrarotlicht ist.

2. Verfahren nach Anspruch 1, wobei das thermoplastische Harz ein Harz auf Polycarbonatbasis ist.

3. Verfahren nach einem der vorangehenden Ansprüche, wobei die thermoplastische Zusammensetzung das thermoplastische Harz in einer Menge zwischen 45 Gew% und 99 Gew%, vorzugsweise zwischen 70 Gew% und 97 Gew% in Bezug auf das Gewicht der gesamten Zusammensetzung umfasst.

4. Verfahren nach einem der vorangehenden Ansprüche, wobei der Laser-Direktstrukturierungszusatz einen CIELab Farbwert L* von mindestens 50, vorzugsweise mindestens 60 und bevorzugter mindestens 75 hat.

5. Verfahren nach einem der vorangehenden Ansprüche, wobei der Laser-Direktstrukturierungszusatz einen CIELab Farbwert a* zwischen -10 und +10 und einen Wert b* zwischen -10 und +10 hat.

6. Verfahren nach einem der vorangehenden Ansprüche, wobei der Laser-Direktstrukturierungszusatz Glimmer umfasst, auf dem das Antimon-dotierte Zinnoxid aufgetragen ist.

7. Verfahren nach einem der vorangehenden Ansprüche, wobei die thermoplastische Zusammensetzung den Laser-Direktstrukturierungszusatz in einer Menge von 2 Gew% bis 25 Gew%, bevorzugter von 3 bis 20 Ges%, noch bevorzugter von 4 bis 15 Gew% und ganz besonders bevorzugt von 5 Gew% bis 10 Gew% in Bezug auf das Gewicht der gesamten Zusammensetzung umfasst.

8. Verfahren nach einem der vorangehenden Ansprüche, des Weiteren umfassend c) ein Pigment, vorzugsweise in einer Menge von mindestens 1 Gew% in Bezug auf das Gewicht der gesamten Zusammensetzung.

9. Verfahren nach Anspruch 8, wobei das Pigment ein weißes Pigment umfasst, das ausgewählt ist aus der Gruppe bestehend aus TiO₂, BaSO₄ oder ZnO.

10. Verfahren nach Anspruch 8 oder 9. wobei die thermoplastische Zusammensetzung das Pigment in einer Menge von mindestens 5 Gew% und vorzugsweise höchsten 20 Gew%, bevorzugter höchstens 10 Gew% in Bezug auf das Gewicht der gesamten Zusammensetzung umfasst.

11. Verfahren nach einem der vorangehenden Ansprüche, des Weiteren umfassend d) einen Mineralfüllstoff, der ausgewählt ist aus der Gruppe bestehend aus Glimmer, Talk und Wollastonit, vorzugsweise in einer Menge von mindestens 1 Gew% und höchstens 10 Gew%.

12. Verwendung von TiO₂ zur Verbesserung der Plattierungsleistung in einem Laser-Direktstrukturierungsverfahren zur Herstellung eines Schaltungsträgers, umfassend: a) ein thermoplastisches Harz und b) einen Laser-Direktstrukturierungszusatz in einer Menge von mindestens 1 Gew% in Bezug auf das Gewicht der gesamten Zusammensetzung, wobei der Laser-Direktstrukturierungszusatz Antimon-dotiertes Zinnoxid umfasst und einen CIELab Farbwert L* von mindestens 45 aufweist, wobei die Laserstrahlung Infrarotlicht ist.

## Revendications

1. Procédé de fabrication d'un support de circuit, comprenant la fourniture d'une pièce moulée contenant une composition thermoplastique comprenant :
a) une résine thermoplastique et
b) un additif de structuration directe par laser en une quantité d'au moins 1% en poids par rapport au poids de la composition totale, l'additif de structuration directe par laser comprenant l'oxyde d'étain dopé d'antimoine et ayant une valeur de couleur CIELab L* d'au moins 45 et
des zones d'irradiation de ladite pièce sur laquelle des pistes conductrices doivent se former par rayonnement laser, et ensuite métalliser les zones irradiées, dans lequel le rayonnement laser est une lumière infrarouge.

2. Procédé selon la revendication 1, dans lequel la résine thermoplastique est une résine à base de polycarbonate.

3. Procédé selon l'une quelconque des revendications précédentes, dans lequel la composition thermoplastique comprend de la résine thermoplastique dans une quantité comprise entre 45 % en poids et 99 % en poids, de préférence entre 70 % en poids et 97 % en poids, par rapport au poids de la composition totale.

4. Procédé selon l'une quelconque des revendications précédentes, dans lequel l'additif de structuration directe par laser a une valeur de couleur CIELab L* d'au moins 50, préférentiellement d'au moins 60, préférentiellement d'au moins 75.

5. Procédé selon l'une quelconque des revendications précédentes, dans lequel l'additif de structuration directe par laser a une valeur de couleur CIELAB a* située entre -10 et +10, et une valeur b* située entre -10 et +10.

6. Procédé selon l'une quelconque des revendications précédentes, dans lequel l'additif de structuration directe par laser comprend du mica sur lesquelles l'oxyde d'étain dopé d'antimoine est appliqué.

7. Procédé selon l'une quelconque des revendications précédentes, dans lequel la composition thermoplastique comprend l'additif de structuration directe par laser en une quantité comprise entre 2 % en poids et 25 % en poids, préférentiellement entre 3 et 20 % en poids, plus préférentiellement entre 4 % en poids et 15 % en poids, et plus préférentiellement de 5 % en poids jusqu'à 10 % en poids, par rapport au poids de la composition totale.

8. Procédé selon l'une quelconque des revendications précédentes, comprenant en outre c) un pigment, de préférence en une quantité d'au moins 1 % en poids par rapport au poids de la composition totale.

9. Procédé selon la revendication 8, dans lequel le pigment comprend un pigment blanc choisi dans le groupe constitué par TiO₂, BaSO₄ ou ZnO.

10. Procédé selon la revendication 8 ou 9, dans lequel la composition thermoplastique comprend le pigment en une quantité d'au moins 5 % en poids et de préférence d'au plus 20 % en poids, plus préférentiellement d'au plus 10 % en poids ; par rapport au poids de la composition totale.

11. Procédé selon l'une quelconque des revendications précédentes, comprenant en outre d) une charge minérale choisie dans le groupe constitué par le mica, du talc et de la wollastonite, de préférence en une quantité d'au moins 1 % en poids et d'au plus 10 % en poids.

12. Utilisation du TiO₂ pour améliorer les performances de placage dans un processus de structuration directe par laser pour la production d'un support de circuit à partir d'une composition thermoplastique comprenant: a) une résine thermoplastique et b) un additif de structuration directe par laser en une quantité d'au moins 1 % en poids par rapport au poids de la composition totale, l'additif de structuration directe par laser contenant de l'oxyde d'étain dopé d'antimoine et ayant une valeur de couleur CIELab L* d'au moins 45, dans lequel le rayonnement laser est une lumière infrarouge,
